# EUROPÄISCHE PATENTSCHRIFT

(11) **EP 0 874 246 B1**
(45) Veröffentlichungstag und Bekanntmachung des Hinweises auf die Patenterteilung: **24.03.2004**
(21) Anmeldenummer: 98104357.3
(22) Anmeldetag: 11.03.1998
(51) Int. Cl.: G01R 33/12

(54) **Verfahren zur kontaktfreien, longitudinalen und transversalen Homogenitätsuntersuchung der kritischen Stromdichte jc in Band-Supraleitern und eine Messapparatur zur Durchführung des Verfahrens**
Method and apparatus for contactless longitudinal and vertical homogeneity measurements of the critical current density jc in superconducting tape
Procédé et appareil pour la mesure sans contact de l'homogénéité longitudinale et transversale de la densité de courant critique jc d'un ruban supraconducteur

(30) Priorität: 24.04.1997 DE 19717283
(43) Veröffentlichungstag der Anmeldung: 28.10.1998
(73) Patentinhaber: Forschungszentrum Karlsruhe GmbH, 76133 Karlsruhe (DE)
(72) Erfinder: Schiller, Heinz-Peter, 76131 Karlsruhe (DE); Schauer, Wolfgang, Dr., 76327 Pfinztal (DE); Reiner, Hans, 76351 Linkenheim-Hochstetten (DE); Polak, Milan, Dr., 84104 Bratislave (SK); Grube, Kai, Dr., 76185 Karlsruhe (DE)

(56) Entgegenhaltungen:
- DE-A- 2 606 504
- DE-A- 4 218 633
- DE-B- 2 431 505

## Beschreibung

Die Erfindung betrifft ein Verfahren zur Ermittung der kritischen Stromdichte j_{c}(x, y) und ihrer Homogenität in Band-Supraleitern und eine Meßapparatur zur Durchführung des Verfahrens.

Die Messung erfolgt induktiv und kontaktfrei in einem Kryostaten, in dem der Band-Supraleiter unter seine Sprungtemperatur gekühlt wird.

Stand der Technik ist z. B. ein resistives Meßverfahren mit Stromeinspeisung in den Band-Supraleiter und Spannungskontakten, entweder nur an den Leiterenden bei isolierten Bandleitern oder mit angebrachten Kontakten oder Spannungsabgriffen über Schleifkontakte bei nichtisolierten Supraleitern. Das ist ein berührendes Meßverfahren.

Die resistive Stromdichtemessung hat gegenüber einem induktiven Verfahren den entscheidenden Nachteil, daß der Prüfling kontaktiert werden muß. Dies ist einerseits aufwendig, zum andern wenig zuverlässig, da insbesondere Bi-2223-Bänder häufig mit einer organischen Schicht behaftet sind, die beim Abgriff nicht reproduzierbare Übergangswiderstände verursacht. Für einen technischen Verfahrensprozeß ist das ungeeignet.

Weiter sind berührungslose Verfahren zu erwähnen, und zwar die Hallsonden-Magnetometrie, wie sie an Y-123-Sputterfilmen (siehe "Magnetic flux mapping, ..." von W. Xing et al. in J. Appl. Phys. 76(7), 1994, Seiten 4244 - 4255, und "Contactless measurement of voltage-current characteristics ..." von M. Polak et al. in Physica C 174 (1991), Seiten 14 - 22) und Bi-2223-Einkernleiterbandstücken (siehe "Homogeneity study of Bi-2223/Ag monofilamentary tapes ..." von Markku Lahtinen et al. in Physica C 244 (1995), Seiten 115 - 122, "Scanning Hallprobe microscopy ..." von A. Tanihata et al. in Supercond. Sci. Technol. 9 (1996), Seiten 1055 - 1059, und "A study on self-field distribution ..." von K. Kawano und A.Oota in Physica C 275 (1997), Seiten 1 - 11) vorgenommen wurde. Bei dem letztgenannten Verfahren werden Eigenfelder aufmagnetisierter Prüflinge mit Hallsonden untersucht. Bei diesen berührungslosen Meßverfahren handelt es sich um Messungen der remanenten Feldverteilung von stationären Kurzproben (im cm-Bereich) nach Aufmagnetisierung im äußeren Feld und dessen Abklingen. Zur Messung der remanenten Feldverteilung wird die Hallsonde über den Prüfling gescannt (x-y-Verschiebetisch). Mit einer Computeranalyse wird die Stromdichteverteilung aus dem ortsabhängigen Hallsignal gewonnen. Ein Durchzugsverfahren wird in dem Siemens Forsch.-u. Entwickl.-Ber. Bd. 5 (1976) Nr. 2, Seiten 98 - 103, beschrieben, bei dem die magnetische Feldstärke von Abschirmströmen außerhalb des Supraleiters durch Hall-Sonden bestimmt wird.

Der Erfindung liegt die Aufgabe zugrunde, ein industriell einsatzfähiges Verfahren und eine Meßapparatur bereitzustellen, mit dem und mit der große Längen von Band-Supraleitern kontinuierlich hinsichtlich der kritischen Stromdichte j_{c}(x, y) und ihrer Homogenität über die Bandlänge vermessen werden können.

Die Aufgabe wird mit einem Verfahren gemäß Anspruch 1 und einer Apparatur gemäß Anspruch 5 gelöst. Gemessen wird berührungslos mit Hall-Sonden, und zwar mit einem Hall-Sonden Array unmittelbar über dem durchlaufenden Supraleiter im äußeren Magnetfeld und mit einer einzelnen Hall-Sonde, der Kompensations-Hall-Sonde, im äußeren Magnetfeld, die so weit vom Supraleiter entfernt ist, daß das von den Abschirmströmen erzeugte Magnetfeld nicht mehr erfaßt wird, bzw. keinen bemerkenswerten Beitrag mehr einbringt. Zur Messung der Längshomogenität genügt eine Hall-Sonde z. B. aus dem Array. Die Querhomogenität wird mit allen Hall-Sonden aus dem Array erfaßt. Alle Hall-Sonden aus dem Array werden mit der einen Hall-Sonde im äußeren Magnetfeld abgeglichen, so daß das jeweilige Differenzsignal ein Maß für die örtliche Homogenität darstellt. Über eine resistive Eichung kann bei bekanntem Supraleiterquerschnitt die ortsabhängige, kritische Stromdichte j_{c} angegeben werden.

In den Unteransprüchen 2 bis 3 sind Verfahrensschritte gekennzeichnet, die das Meßverfahren einfach handhabbar machen, so wie auch in den Unteransprüchen 6 bis 8 ein apparativer Aufbau gekennzeichnet ist, mit der die Messung zuverlässig durchgeführt werden kann.

Der Vorteil der Erfindung liegt darin, daß sie ein schnelles und einfach handhabbares Verfahren zur Ermittlung der Stromdichtehomogenität (TACHO = Test of Tape Current Homogeneity) von Band-Supraleitern in Längs- und Querrichtung anbietet. Das Verfahren ermöglicht, Defektstellen im Band, die sich durch einen Einbruch der Stromtragfähigkeit manifestieren, auf einer mm-Skala zu lokalisieren. Bei einer Computersteuerung für den Betrieb und die Datenerfassung ist eine vollautomatische Qualitätskontrolle für Band-Supraleiter über die gesamte angefertigte Fertigungslänge (km-Bereich!) realisierbar.

Das erfindungsgemäße Verfahren und die Apparatur zur Durchführung desselben werden im folgenden anhand der Zeichnung näher erläutert.

Es zeigen:

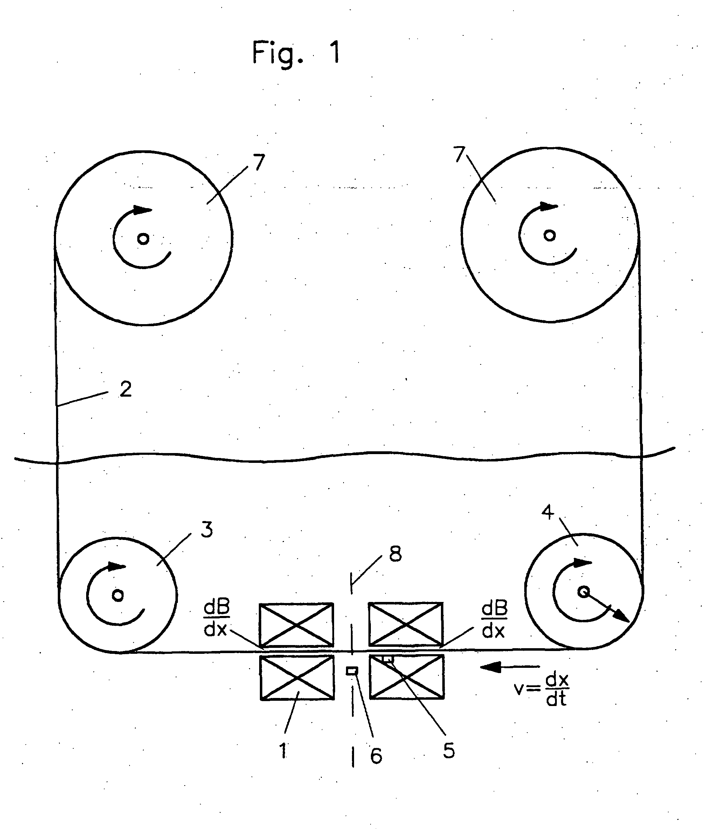

Figur 1 den prinzipiellen apparativen Aufbau der Meßeinrichtung,
Figur 2 eine mit dem Verfahren aufgezeichnete, örtlich periodische Defektstruktur in einem Bi-2223-Supraleiterband,
Figur 3 induktiv und resistiv nachgewiesene Banddefekte mit resistiver Stromeichung,
Figur 4 das spiegelsymmetrisches Hallsignal bei Umkehrung der Bandlaufrichtung,
Figur 5 die Aufzeichnung der Längs- und Querhomogenität des Hallsignals in einem Bi-2223-Band mittels eines Hall-Sonden-Arrays.

Das Verfahren wird in diesem Durchführungsbeispiel bei 77 K in Magnetfeldern bis 0,1 T durchgeführt. Als Kühlmittel dient flüssiger Stickstoff (LN₂). Es ist aber mit entsprechendem kryotechnischen Aufwand auch auf andere Temperatur- und Magnetfeldbereiche erweiterbar.

Der Band-Supraleiter 2 wird bei 77 K mit einer Geschwindigkeit von einigen mm/sec durch den Spalt des Magneten 1, hier eine Kupferspule in split-coil-Geometrie, gezogen. Dabei induziert das vom Band als zeitlich verändertlich wahrgenommene Magnetfeld (dB/dt = (dB/dx)·(dx/dt), mit dx/dt = v = Band-Durchzugsgeschwindigkeit) Abschirmströme im Band-Supraleiter 2, die dem Modell des kritischen Zustandes zufolge mit der kritischen Stromdichte fließen. Diese Abschirmströme erzeugen ihrerseits ein Magnetfeld, welches in diesem beschriebenen Fall mit einer Miniatur-HallSonde 5 von 50 µm x 50 µm aktiver Fläche gemessen wird. (Solche Sonden sind derzeit kommerziell erhältlich.) Die Sonde 5 befindet sich 0,4 mm über dem Band 2 im Spalt unter der Spulenwicklung, wo das Spulenfeld einen weitgehend ortsunabhängigen Gradienten dB/dx hat. Dies ist Voraussetzung für eine bei festem elektrischen Feld E ≈ dB/dt = dB/dx·v durchzuführende Magnetisierungsmessung, aus der der kritische Strom bestimmt wird. Zur Messung des Probenfeldes der Abschirmströme, üblicherweise < 1 mT, muß das um 2 bis 3 Größenordnungen stärkere äußere Spulenfeld kompensiert werden. Dies geschieht mit einer zweiten, möglichst baugleichen Hallsonde 6, mit der das Differenzsignal beider Hall-Sonden 5, 6 in einer Leermessung (ohne Probe) auf Null abgeglichen wird. Diese Kompensations-Hallsonde 6 befindet sich außerhalb des Feldbereichs der Abschirmströme. Gemessen wird das Differenzsignal beider Sonden 5, 6, das bei vorhandener Probe von Null verschieden ist.

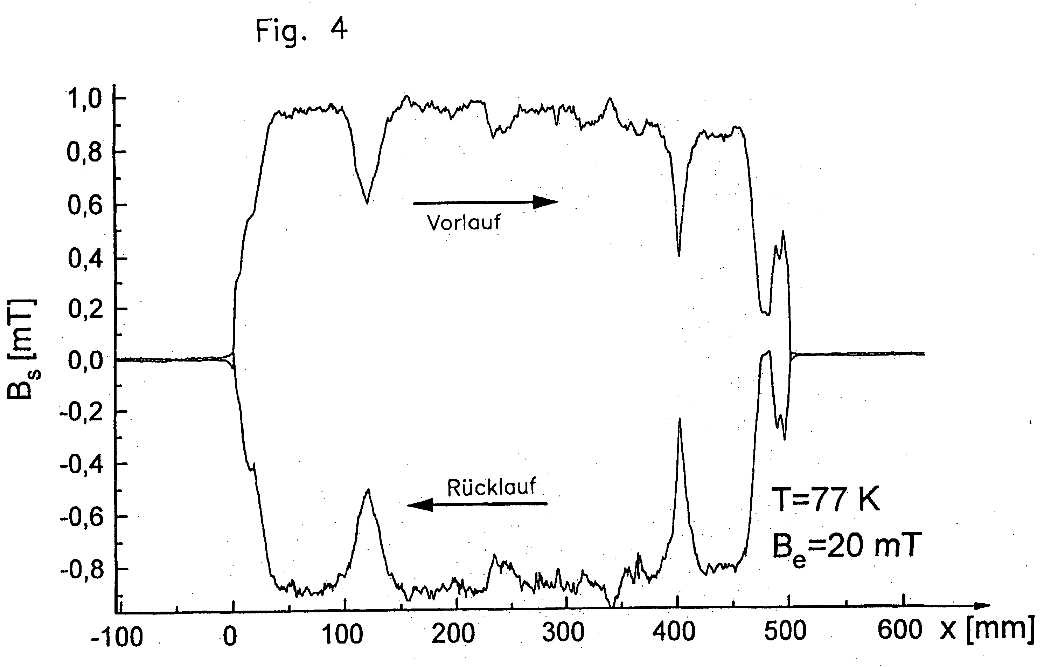

Die exakte Positionierung des Bandes erfolgt durch Kupfer-Beryllium-Federn und Saphir-Andruckschienen. Der Abstand Band - Hallsonde ist kritisch und muß beim Durchlauf auf etwa 0,05 mm konstant bleiben. Abstandsvariationen > 0,1 mm sind deutlich im Hallsignal nachweisbar. Daß die erforderliche Abstandstoleranz eingehalten wird, dokumentiert Fig. 4, wobei beim Richtungswechsel der Durchlaufgeschwindigkeit ein exakt spiegelsymmetrisches Hallsignal registriert wird.

Ein Wegaufnehmer mißt die Bandposition in Durchlaufrichtung.

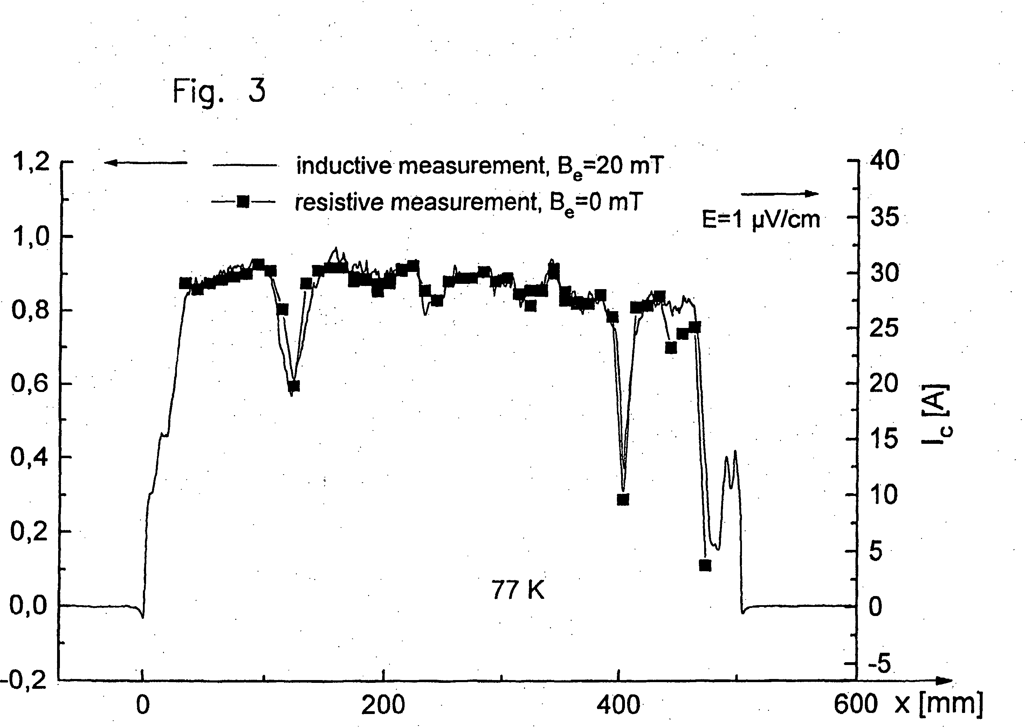

Die kritische Stromdichte kann aus dem Hall-Sonden-Differenzsignal unter der Annahme einer zweidimensionalen Stromverteilung j_{c}(x, y) in der Bandebene, d. h. konstante Stromdichte über die Banddicke, mit einem Inversionsverfahren berechnet werden. Bei komplizierteren Stromverteilungen, wie der in einem supraleitenden Vielkern-Leiter, ist das Hallsondensignal ein qualitatives Maß für die Stromdichte, das Inhomogenitäten auf einer mm-Skala zu detektieren in der Lage ist. Quantitative Angaben können stets durch eine resistive Eichung getroffen werden, bei der lokale Strom-Spannungs-Messungen am zu prüfenden Supraleiter vorgenommen werden (Figur 3).

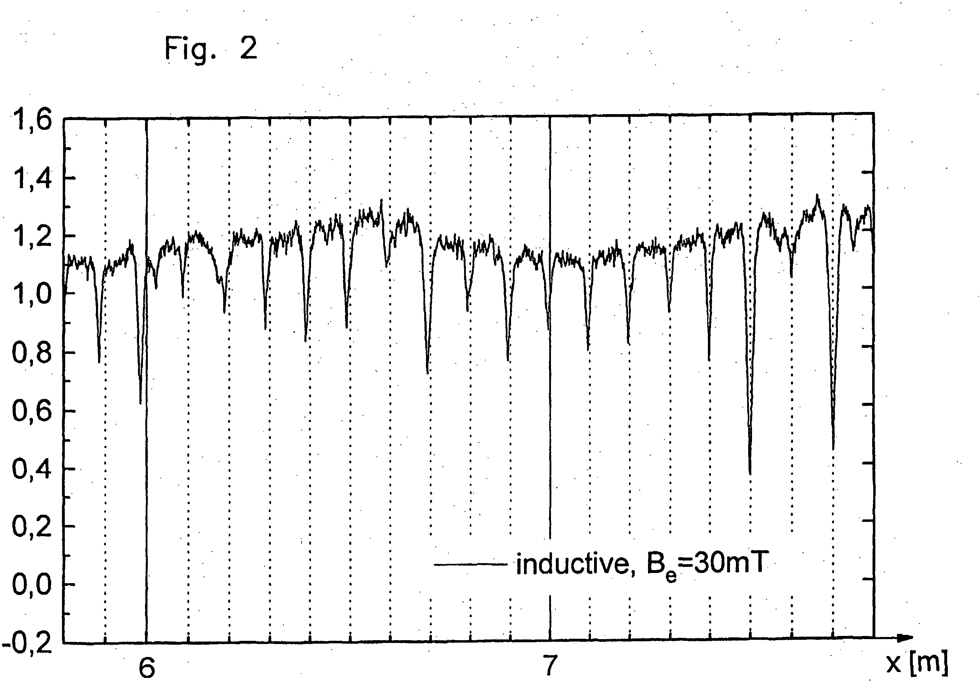

Figur 2 zeigt die ausschnittsweise Aufnahme eines supraleitenden Bi-2223-Bandes großer Länge, das dem Meßverfahren TACHO unterzogen wurde. Feldeinbrüche treten hier mit einer Regelmäßigkeit von etwa 10cm Priodizitätslänge auf und sind mehr oder weniger stark ausgeprägt. Damit ist zunächst die qualitative Aussage über den Verlauf der Längshomogenität der kritischen Stromdichte j_{c}(x) möglich, die über eine resistive Eichung quantitativ angegeben werden kann. Jetzt ist entscheidbar, ob der Sollwert der kritische Stromdichte j_{c} unterschritten wird oder nicht.

Figur 3 zeigt einen Ausschnitt von etwa einem halben Meter Länge aus der Vermessung des Bi-2223-Band-Supraleiters. Die linke Ordinate gibt das Hall-Sonden-Signal in in mT an (induktives Signal), die rechte die entsprechende Stromtragfähigkeit des Bandes in A bei 1 µV/cm E-Feld-Kriterium (resistive Eichung). Hierbei wurde das berührungslose, induktive dem berührenden, resistiven Meßverfahren gegenübergestellt und durch die Koinzidenz des j_{c}(x)-Verlaufs die Leistungsfähigkeit des induktiven Verfahrens unter Beweis gestellt, wie der Meßkurvenverlauf zeigt.

Um die Zuverlässigkeit des Verfahrens unter Beweis zu stellen, wird ein beliebiges Bi-2223-Bandstück über etwa 0,5 m Länge dem Meßverfahren zur Ermittlung der Längshomogenität in einem Hin- und Rücklauf unterzogen. Die Messung des Verlaufs des Magnetfeldes B in mT zeigt Figur 4. Der spiegelbildliche Verlauf der Rücklaufmessung kommt exakt zum Ausdruck.

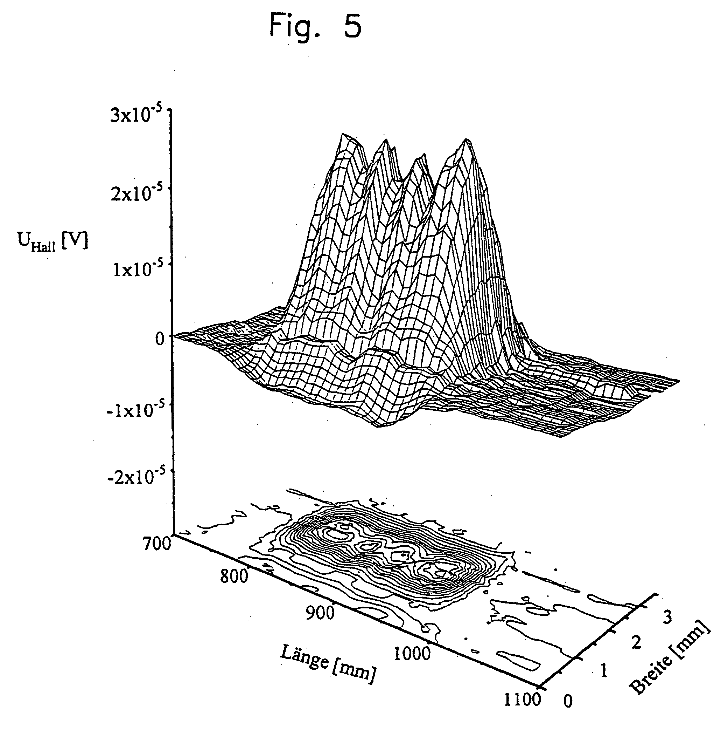

Die gleichzeitige Ermittlung der Längs- und Querhomogenität mit dem quer zur Leiterlängsachse liegenden Hall-Sonden-Array ist letztendlich das Ziel, das mit dem TACHO-Verfahren erreicht werden soll. Mit der Darstellung der Stromdichte über den Leiterquerschnitt und über die Leiterlänge kann eine genaue Aussage über die Qualität des Supraleiter-Bandes gemacht werden. In Figur 5 ist dazu dreidimensional der Hallspannungsverlauf und darunter seine Projektion als Höhenliniendarstellung über eine Bi-2223-Bandlänge von etwa 20 cm aufgezeichnet worden. Das darin dargestellte "Hall-Spannungsgebirge" ist durch den Verlauf der Stromdichte des Bandleiterstücks in Längs- und Querrichtung bestimmt.

### Bezugszeichenliste

- 1: Magnet, Spulenwicklung
- 2: Band-Supraleiter, Band
- 3: Umlenkrollen
- 4: Umlenkrollen
- 5: Hall-Sonde, Array
- 6: Hallsonde, Kompensations-Hallsonde
- 7: Spuleinrichtung
- 8: Magnetachse, Achse

## Patentansprüche

1. Verfahren zur kontaktfreien, longitudinalen und transversalen Homogenitätsuntersuchung der kritischen Stromdichte j_{c} mittels Hall-Sonden (5, 6) in einem unter die Sprungtemperatur T_{c} abgekühlten Band-Supraleiter (2), wobei derselbe durch ein äußeres, lokal begrenztes, mit einem konstanten Gradienten behaftetes Magnetfeld B(x, y, z) gezogen wird, dessen Magnetfeldachse (8) während der Messung nicht verändert wird,
**dadurch gekennzeichnet, daß**
das Magnetfeld, das von den im vom äußeren Magnetfeld durchdrungenen Bereich des Band-Supraleiters (2) induzierten Abschirmströmen herrührt, mit einer ersten, dem Band-Supraleiter (2) wenige zehntel Millimeter nahen Hallsonde (5) abgetastet wird,
mit einer zweiten, der ersten Hallsonde (5) möglichst baugleichen Hallsonde (6), der Kompensations-Hallsonde, das äußere Magnetfeld außerhalb des Feldbereichs der induzierten Abschirmströme gemessen wird, nachdem zuvor in einer Leermessung ohne Prüfling das äußere Magnetfeld alleine von beiden Hallsonden (5, 6) gemessen und die Differenz beider Hallsonden-Signale auf Null abgeglichen wurde,
die Differenz aus dem ersten und zweiten Hallsonden-Signal als qualitatives Maß für die hinsichtlich der Längsachse des Band-Supraleiters (2) örtlich variierende kritische Stromdichte j_{c}(x) und deren Verlauf als Längshomogenität herangezogen wird,
mit einem vorzugsweisen linearen Hall-Sonden-Array (5), das quer zur Längsachse des Band-Supraleiters (2) liegt und sich über die Leiter-Breitseite erstreckt, die Querhomogenität gemessen wird, nachdem zuvor für alle Hall-Sonden des Arrays (5) ebenfalls der Nullabgleich mit dem Signal der Kompensations-Sonde (6) durchgeführt wurde,
die örtlich kritischen Stromdichten j_{c}(x, y) aus den Hallsonden-Signalen über eine resistive Eichung als Strom-Spannungs-Messung quantitativ angegeben werden.

2. Verfahren nach Anspruch 1,
**dadurch gekennzeichnet, daß**
die Achse (8) des äußeren Magnetfelds so ausgerichtet wird, daß sie senkrecht auf der Breitseite des Band-Supraleiters (2) steht und dessen Längsachse schneidet.

3. Verfahren nach Anspruch 2,
**dadurch gekennzeichnet, daß**
mit der Kompensations-Hallsonde (6) an einem vorgegebenen Ort das äußere Magnetfeld unbeeinflußt vom Magnetfeld des Band-Supraleiters gemessen wird.

4. Apparatur zur Durchführung des Verfahrens nach den Ansprüchen 1 bis 3, bestehend aus:
- einem mit Kühlmittel auffüllbaren Kryostaten zur Einstellung und Aufrechterhaltung einer für die Supraleitung notwendigen Temperatur,
- einem Magnet (1), der in diesem Kryostaten untergebracht ist, zwischen dessen beiden Polen der zu prüfende Band-Supraleiter (2) in einer Führung mit Positionier- und mit Positionsgebereinrichtung durchgezogen wird,
- zwei Umlenkrollen (3, 4) in diesem Kryostaten, die derart dimensioniert und untergebracht sind, daß der Band-Supraleiter (2) der Führung im Zwischenpolbereich ungeschädigt übergeben bzw. aus ihr übernommen wird,
- einer ersten Hall-Sonde (5) im Zwischenpolbereich des Magneten (1) zum Erfassen des von den Abschirmströmen im Band-Supraleiter (2) erzeugten Magnetfelds und einer zweiten Hall-Sonde (6), der Kompensations-Hall-Sonde, im von dem Magneten (1) erzeugten Magnetfeld, die außerhalb des von den Abschirmströmen erzeugten Magnetfelds liegt,
- einem (linearen) Array (5) aus weiteren Hall-Sonden, das quer zur Längsachse und parallel zur Breitseite des zwischen den Magnetpolen durchzuziehenden Band-Supraleiters (2) angebracht ist, wobei die erste Hall-Sonde (5) Bestandteil dieses Arrays (5) ist oder nicht,
- einer Spuleinrichtung (7) außerhalb des Kryostaten, die in ihrem Drehmoment derart steuerbar ist, daß der zu prüfende Band-Supraleiter (2) im Zwischenpolbereich vorwärts oder rückwärts eine vorgegebene konstante Geschwindigkeit hat,
- zwei Führungen auf einem den Kryostaten abschließenden Deckel, die den Band-Supraleiter (2) in und aus dem Kryostaten führen.

5. Apparatur nach Anspruch 4,
**dadurch gekennzeichnet, daß**
der Magnet (1) zum Erzeugen des äußeren Magnetfelds ein Permanentmagnet ist.

6. Apparatur nach Anspruch 4,
**dadurch gekennzeichnet, daß**
der Magnet (1) ein normalleitender oder supraleitender Elektromagnet ist, mit dem ein zeitlich konstantes, in seiner Stärke wählbares Magnetfeld eingestellt werden kann.

7. Apparatur nach Anspruch 6,
**dadurch gekennzeichnet, daß**
der Magnet (1) ein sogenanntes Split-Coil-Solenoid ist.

8. Apparatur nach Anspruch 5 und 7,
**dadurch gekennzeichnet, daß**
sämtliche Hall-Sonden (5, 6) Miniatur-Hallsonden sind, die jeweils, je nach Anforderung an die Ortsauflösung, eine aktive Fläche von höchstens 100 µm x 100 µm haben.

## Claims

1. Process for the contact-free, longitudinal, and transverse measurement of homogeneity of critical current density j_{c} using Hall probes (5, 6) in a band-type superconductor (2) cooled down below the transition temperature T_{c}, with this superconductor being drawn through an external, locally restricted, constant-gradient magnetic field B(x, y, z), the axis of which (8) is not changed during measurement,
**characterized by**
the magnetic field that is generated by shielding currents induced by that area of the band-type superconductor (2) that is exposed to the external magnetic field being scanned with a first Hall probe (5) that is located a few tenths of a millimeter away from the band-type superconductor (2),
a second Hall probe (6), if possible, identical in construction with the first Hall probe (5), that is referred to as the compensating Hall probe measuring the external magnetic area outside of the area of the induced shielding currents after the external magnetic field was measured alone by both Hall probes (5, 6) without test sample and the difference of both Hall probe signals was set to zero,
the difference between the first and the second Hall probe signal being a qualitative measure of the locally varying critical current density j_{c}(x) relative to the longitudinal axis of the band-type superconductor (2) and its behavior which is referred to as longitudinal homogeneity,
a preferably linear Hall probe array (5) located transverse to the longitudinal axis of the band-type superconductor (2) and extending along the wide side of the conductor measuring transverse homogeneity following zero balancing with the signal of the compensating probe (6) for all Hall probes of the array (5),
the locally critical current densities j_{c}(x, y) resulting quantitatively as current-voltage measurement from the Hall probe signals through resistive calibration.

2. Process according to Claim 1,
**characterized by**
the axis (8) of the external magnetic field being oriented such that it is vertical to the wide side of the band-type superconductor (2) and intersects its longitudinal axis.

3. Process according to Claim 2,
**characterized by**
the compensating Hall probe (6) measuring the external magnetic field at a given point, unaffected by the magnetic field of the band-type superconductor.

4. System for the execution of the process according to Claims 1 through 3, consisting of:
- A cryostat that can be filled with a coolant for adjusting and maintaining a temperature required for superconductivity,
- a magnet (1) accommodated in this cryostat, between the two poles of which the band-type superconductor (2) to be tested is drawn through in a guiding mechanism with a positioning device and a position transmitter,
- two deflection pulleys (3, 4) in this cryostat, which are dimensioned and accommodated such that the band-type superconductor (2) is passed on to or taken over by the guiding mechanism in the area between the poles,
- a first Hall probe (5) in the area between the poles of the magnet (1) to measure the magnetic field generated in the band-type superconductor (2) by the shielding currents and a second Hall probe (6), the compensating Hall probe, in the magnetic field generated by the magnet (1), which is located outside of the magnetic field generated by the shielding currents,
- a (linear) array (5) of additional Hall probes that is arranged transverse to the longitudinal axis and parallel to the wide side of the band-type superconductor (2) that is to be drawn through between the magnetic poles, with the first Hall probe (5) being part of this array (5) or not,
- a reel (7) outside of the cryostat, the torque of which can be controlled such that the band-type superconductor (2) to be tested in the area between the poles has a given constant forward or backward speed,
- two guiding mechanisms on a lid to close the cryostat, which guide the band-type superconductor (2) into and from out of the cryostat.

5. System according to Claim 4,
**characterized by**
the magnet (1) for the generation of the external magnetic field being a permanent magnet.

6. System according to Claim 4,
**characterized by**
the magnet (1) being a normal-conducting or superconducting solenoid, by means of which a magnetic field constant with time and with a choosable intensity can be set.

7. System according to Claim 6,
**characterized by**
the magnet (1) being a so-called split-coil solenoid.

8. System according to Claims 5 and 7,
**characterized by**
all Hall probes (5, 6) being miniaturized Hall probes with an active surface area of 100 µm x 100 µm at the maximum, depending on the required local resolution.

## Revendications

1. Procédé d'étude d'homogénéité sans contact, longitudinal et transversal de la densité de courant critique j_{c} à l'aide de sondes de Hall a(5, 6) dans un supraconducteur de bande (2) refroidi au dessous de la température de transition T_{c}, celui-ci étant tiré à travers un champ magnétique B (x, y, z) extérieur, limité localement, chargé d'un gradient constant et dont l'axe de champ magnétique (8) n'est pas modifié pendant la mesure,
**caractérisé en ce que**
le champ magnétique qui provient des courants de blindage induits dans le domaine du supraconducteur de bande (2) pénétré par le champ magnétique extérieur, est analysé par une première sonde de Hall (5) située quelques dixièmes de millimètres près du supraconducteur de bande (2),
que le champ magnétique extérieur est mesuré à l'extérieur du domaine de champ des courants de blindage induits, à l'aide d'une deuxième sonde de Hall (6), la sonde de Hall de compensation, de construction identique si possible à celle de la première sonde de Hall (5), après avoir mesuré le champ magnétique extérieur seulement par les deux sondes de Hall (5, 6), par une mesure à vide sans éprouvette, et après avoir compensé à zéro la différence des deux signaux des sondes de Hall,
que la différence entre le premier et le deuxième signal de la sonde de Hall est utilisé comme critère qualitatif de la densité de courant critique j_{c}(x) variant localement par rapport à l'axe longitudinal du supraconducteur de bande (2) et de l'évolution de celle-ci en tant qu'homogénéité longitudinale,
que l'homogénéité transversale est mesurée par un dispositif de mesure à sonde de Hall, de préférence linéaire, situé transversalement par rapport à l'axe longitudinal du supraconducteur de bande (2) et qui s'étend sur le côté large du conducteur, après avoir effectué, pour toutes les sondes de Hall du dispositif de mesure (5), la compensation à zéro avec le signal de la sonde de compensation (6),
que les densités de courant j_{c}(x, y) localement critiques des signaux des sondes de Hall sont indiquées quantitativement comme mesure de courant-tension par un étalonnage résistif.

2. Procédé selon la revendication 1,
**caractérisé en ce que**
l'axe (8) du champ magnétique extérieur est orienté de telle façon qu'il est perpendiculaire au côté large du supraconducteur de bande (2) et qu'il coupe l'axe longitudinal de celui-ci.

3. Procédé selon la revendication 2,
**caractérisé en ce que**
la sonde de Hall (6) de compensation mesure le champ magnétique extérieur à un endroit donné, indépendamment du champ magnétique du supraconducteur de bande.

4. Appareillage pour réaliser le procédé selon les revendications 1 à 3, composé de:
- un cryostat remplissable de produit réfrigérant pour régler et maintenir une température nécessaire à la supraconduction,
- un aimant (1) logé dans ce cryostat, entre les pôles duquel le supraconducteur de bande (2) à essayer est passé dans une coulisse de guidage équipée d'un dispositif de positionnement et de transmission de position,
- deux poulies de guidage (3, 4) dans ce cryostat qui sont dimensionnées et disposées de telle façon que le supraconducteur de bande (2) peut être remis à la coulisse de guidage dans la zone interpolaire et repris de celle-ci respectivement, sans subir de dommage,
- d'une première sonde de Hall (5) dans la zone interpolaire de l'aimant (1) pour détecter le champ magnétique produit par les courants de blindage dans le supraconducteur de bande (2) ainsi que d'une deuxième sonde de Hall (6), la sonde de Hall de compensation, dans le champ magnétique produit par l'aimant (1), celle-ci se trouvant à l'extérieur du champ magnétique produit par les courants de blindage,
- d'un dispositif (linéaire) (5) d'autres sondes de Hall placé transversalement par rapport à l'axe longitudinal et parallèlement au côté large du supraconducteur de bande (2) à faire passer entre les pôles magnétiques, la première sonde de Hall (5) faisant partie intégrante ou non de ce dispositif (5),
- d'un dispositif de bobinage (7) à l'extérieur du cryostat, dont le couple peut être réglé de telle façon que le supraconducteur de bande (2) à essayer présente dans la zone interpolaire une vitesse d'avancement et de retour donnée constante,
- deux coulisses de guidage placées sur un couvercle obturant le cryostat et qui guident le supraconducteur de bande (2) dans le cryostat et à l'extérieur de celui-ci.

5. Appareillage selon la revendication 4,
**caractérisé en ce que**
l'aimant (1) produisant le champ magnétique extérieur est un aimant permanent.

6. Appareillage selon la revendication 4,
**caractérisé en ce que**
l'aimant (1) est un électroaimant de conduction normale ou supraconducteur permettant de régler un champ magnétique constant dans le temps, d'intensité variable.

7. Appareillage selon la revendication 6,
**caractérisé en ce que**
l'aimant (1) est un dit "split coil solenoid".

8. Appareillage selon les revendication 5 et 7,
**caractérisé en ce que**
l'ensemble des sondes de Hall (5, 6) sont des sondes de Hall en miniature qui, selon la résolution locale exigée, présentent une surface active maximale de 100 µm x 100 µm.
